# EUROPEAN PATENT APPLICATION

(11) **EP 0 935 343 A1**
(43) Date of publication of application: **11.08.1999**
(21) Application number: 98929782.5
(22) Date of filing: 01.07.1998
(51) Int. Cl.: H03K 3/313, H01L 21/82, H01L 27/04, H01L 29/86

(54) **SR FLIP FLOP**

(30) Priority: 08.07.1997 JP 21691597
(71) Applicant: MASUDA, Tatsuji, Matsuyama-shi Ehime-ken 790 (JP)
(72) Inventor: MASUDA, Tatsuji, Matsuyama-shi Ehime-ken 790 (JP)
(74) Representative: Moir, Michael Christopher
(86) International application number: PCT/JP98/02959
(87) International publication number: WO 99/03204

(57) **Abstract**

A SR flip-flop using a device which has negative resistance between two output electrodes provided on one of two semiconductor regions in a fixed reversible reverse breakdown condition of the semiconductor junction formed between the two semiconductor regions. The SR motion is controlled by applying trigger pulses directly to two output electrodes. In this way, the circuit is simplified and the operation speed is raised.

## Description

The present invention relates to a SR flip-flop, for example a SR flip-flop using a device which has negative resistance between two output electrodes provided on one of two semiconductor regions in a fixed reversible reverse break-down condition of the semiconductor junction formed between the two semiconductor regions.

The SR flip-flop has been to date made by the circuit of feedback means using three terminal two active devices. As a result, the device comes to have complexity in the circuit structure and its operation speed cannot help being reduced. To settle these problems, the SR flip-flop of the present invention is constructed by the bistable circuit using the device, which is mentioned in US PATENT DOCUMENT 5,229,636 or JP PATENT DOCUMENT 5-60270.

The present invention provides a SR flip-flop comprising:
(a) a semiconductor device including:
   a first semiconductor region having a first conductivity type and a second semiconductor region having a second conductivity type, said two semiconductor regions forming a semiconductor junction therebetween, said semiconductor junction being reversibly biased in the reverse direction by a breakdown voltage, said two semiconductor regions being limited within areas near said depletion region of said semiconductor junction such that carriers accelerated in said depletion region maintain the high energy condition;
   two output electrodes provided on said first semiconductor region, said two output electrodes applying reversibly said breakdown voltage to bias said semiconductor junction;
   one electrode provided on said second semiconductor region, said one electrode applying reversibly said break-down voltage to bias said semiconductor junction with said two output electrodes wherein a bistable condition is obtained at said each of two output electrodes in a fixed reversible reverse breakdown condition of said semiconductor junction;
   two identical first resistors, one terminal of each of said two identical first resistors being connected to one of said two output electrodes; and
   an electrical power source coupled between the common terminal of the other side of said two identical first resistors and said one electrode, said power source providing the voltage to bias said semiconductor junction by said breakdown voltage;
(b) two identical trigger pulse generators, said two identical trigger pulse generators each having an output terminal, each output terminal being connected to one of said two output electrodes wherein the motion of SR flip-flop is obtained between said two output electrodes by applying the trigger pulses of said two identical trigger pulse generators in said bistable condition.

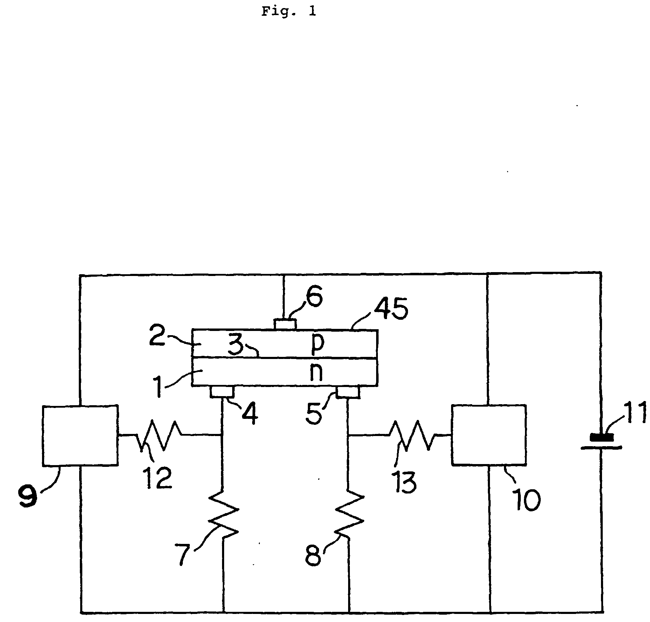

The enclosed figure 'Fig' illustrates the best form of a SR flip-flop of the present invention.

The present invention uses the semiconductor device 45 as an active device of the SR flip-flop. Semiconductor device 45 comprises first semiconductor region 1 of first conductivity type and second semiconductor region 2 of second conductivity type and two output electrodes 4 and 5 in first semiconductor region 1 and electrode 6 in second semiconductivity region 2 which applies with two output electrodes 4 and 5 the breakdown voltage in reverse direction to semiconductor junction 3 formed between first and second semiconductor region 1 and 2. And semiconductor device 45 has bistable output at two output electrodes 4 and 5 which is based on the negative resistance generated between two output electrodes 4 and 5 in a fixed reversible reverse breakdown condition of said semiconductor junction 3.

Here, the first and second semiconductor region 1 and 2 have the area such that carriers which have been accelerated in the depletion region of semiconductor junction 3 maintain their high energy condition. For example, it is less about 10 µm on a side of the rectangle for the stretch and less about 1 µm for the thickness in the planer structure.

The bistable circuit using semiconductor device 45 is hence fabricated as follows. Namely, each one side terminal of two identical resistors 7 and 8 are connected respectively to electrodes 4 and 5 in region 1. Electrical power source 11 is connected between the common terminal of the other sides of two identical resistors 7 and 8 and electrode 6 in region 2 which applies a predetermined voltage to junction 3.

The SR flip-flop of the present invention is constructed based this bistable circuit. Namely, the output terminals of two identical trigger pulse generators 9 and 10 are connected respectively to electrodes 4 and 5 of the bistable circuit directly or through resistive or capasitive means. In this construction, device 45 displays the bistable output at two output electrodes 4 and 5 in a fixed reversible reverse breakdown condition of the semiconductor junction 3 through which the settled power current is flowing.

The arrangement of SR flip-flop motion is explained as follows. The trigger pulses generated by generators 9 and 10 is firstly set to be '1' condition. And, when one of electrodes 4 and 5 has been applied the trigger pulse by the corresponding generators 9 or 10, its electrical potential condition has been turned over, and therefore it is set that the condition before the bistable condition turned over is '0' condition and the condition after the bistable condition turned over is '1' condition.

The explanation of the practical motion is as follows. For example, in the case the bistable condition is that the electrical potential of electrode 4 is low and that of electrode 5 is high, and then the closed current is flowing along the circuit formed by the circular sequence of electrode 5, resistor 8, 7, electrode 4 and region 1. And trigger pulses of '1' are positive trigger pulses. In this condition, when only electrode 5 has been applied a trigger pulse '1' by generators 10, the closed current flowing through electrode 5 decreases in an instant. This decreasing of the current has an effect of weakening the numeral contribution to the negative resistance in the near area of electrode 5 of both the minority carriers of low energies which have not yet been accelerated in the depletion region of semiconductor junction 3 and the majority carriers of high energies which have been accelerated in the depletion region.

This decline drives the bistable condition of device 45 to turn over. Then, the electrical potential of electrode 5 changes from high condition '0' to low condition '1'.

In the other elementary case of SR motion that the trigger pulses '1' are applied to both two electrodes 4 and 5, the driving effects are canceled out mutually and the bistable condition is not turned over. As well, in the case that the trigger pulses '1' are not applied to both electrodes 4 and 5, the bistable condition is not apparently turned over.

In this way, the SR motion is carried out precisely by applying trigger pulses '1' directly to two output electrodes 4 and 5.

Fig is a simplified diagram illustrating the best form of a circuit construction of a SR flip-flop in accordance with the present invention.
- 1: first semiconductor region
- 2: second semiconductor region
- 3: pn semiconductor junction
- 4,5,6: electrodes
- 7,8: first resistors
- 9,10: negative pulse generators
- 11: electrical power source
- 12,13: second resistors
- 45: semiconductor device

Fig shows a simplified diagram illustrating the best form of a circuit construction of a SR flip-flop in accordance with the present invention.

As shown in Fig, semiconductor device 45 comprises first semiconductor region 1 of n type conductivity and second semiconductor region 2 of p type conductivity and two output electrodes 4 and 5 in first semiconductor region 1 and electrode 6 in second semiconductor region 2. Semiconductor junction 3 is formed between first and second semiconductor region 1 and 2. Electrode 4 is connected to the one side terminal of resistor 7 and to the output terminal of negative pulse generator 9 through second resistor 12. Electrode 5 is connected to the one side terminal of resistor 8 and to the output terminal of negative pulse generator 10 through second resistor 13. The resistance of identical resistors 12 and 13 is larger than that of identical resistors 7 and 8. Electrical power source 11 is coupled between the common terminal of the other sides of two identical resistors 7 and 8 and electrode 6 which is biasing pn junction 3 by reversible breakdown voltage in reverse direction. Generators 9 and 10 have the same power source 11 as device 45. The base electrical potential of the negative trigger pulses generated by generators 9 and 10 is made to be medium of the bistable output potential at electrodes 4 and 5. In this construction, device 45 displays the bistable output at two output electrodes 4 and 5 in a fixed reversible reverse breakdown condition of the semiconductor junction 3 through which the settled power current is flowing.

In this condition, the motion of the SR flip-flop is explained as follows. For example, in the case that the bistable condition is that the electrical potential of electrode 4 is low and that of electrode 5 is high, the closed current which generates by the negative resistance between electrodes 4 and 5 is flowing along the circuit formed by the circular sequence of electrode 5, resistor 8, 7, electrode 4 and region 1. Here, since the base electrical potential of the trigger pulses is the medium of the bistable output potentials, the current which is flowing along the same direction as the closed current is flowing on one hand from high potential electrode 5 to negative trigger pulse generator 10 and on the other hand from negative trigger pulse generator 9 to low potential electrode 4. This current is made to be smaller than the closed current so that the bistable condition can be maintained. And the negative trigger pulses generated by the generator 9 and 10 is made to be very small. In this condition, when only low potential electrode 4 has been applied a negative trigger pulse '1' of set pulse by generator 9, the closed current flowing into electrode 4 decreases in an instant. This decreasing of the current has an effect that the number of holes, minority carriers, injected from electrode 4 to region 1 has decreased in an instant and that the number of electrons, majority carriers, injected from region 1 to electrode 4 has increased in an instant, and so has an effect of weakening the numeral contribution to the negative resistance near the area of electrode 4 of both the minority carriers of low energies and the majority carriers of high energies.

This decline drives the bistable condition of device 45 to turn over, and then, the electrical potential of electrode 4 changes from low condition '0' to high condition '1' of set condition.

Nextly when only electrode 5 which becomes to be low potential condition has been applied a negative trigger pulse '1' of reset pulse by generator 10, the closed current flowing into electrode 5 at this time decreases in an instant, and then, the bistable condition has turned over, resulting in that the electrical potential of electrode 5 changes from low condition '0' to high condition '1' of reset condition.

In the case that the negative trigger pulses '1' are applied to both two electrodes 4 and 5, the driving effects are canceled out mutually and the bistable condition is not turned over. And in the case that the negative trigger pulses '1' are not applied to both two electrodes 4 and 5, the bistable condition is not apparently turned over.

In this way, the SR motion is carried out precisely by applying very small trigger pulses '1' directly to two output electrodes 4 and 5.

As explained above, the circuit of the SR flip-flop of the present invention is simplified since it uses the semiconductor device which has bistable output based on the negative resistance generating between the two output electrodes provided in one of the two semiconductor regions in a fixed reversible reverse breakdown condition of the semiconductor junction formed by the two semiconductor regions. And we can make the best use of the high speed faculty of the semiconductor device since the bistable outputs can be controlled by applying directly very small trigger pulses to the two output electrodes. Further, since the reversible reverse breakdown voltage of the junction can be settled in wide range and since the semiconductor device and the circuit is constructed by silicon semiconductor, the circuit can be integrated.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

A SR flip-flop using a device which has negative resistance between two output electrodes provided on one of two semiconductor regions in a fixed reversible reverse breakdown condition of the semiconductor junction formed between the two semiconductor regions. The SR motion is controlled by applying trigger pulses directly to two output electrodes. In this way, the circuit is simplified and the operation speed is raised.

## Claims

1. A SR flip-flop comprising:
(a) a semiconductor device including:
a first semiconductor region having a first conductivity type and a second semiconductor region having a second conductivity type, said two semiconductor regions forming a semiconductor junction therebetween, said semiconductor junction being reversibly biased in the reverse direction by a breakdown voltage, said two semiconductor regions being limited
within areas near said depletion region of said semiconductor junction such that carriers accelerated in said depletion region maintain the high energy condition;
two output electrodes provided on said first semiconductor region, said two output electrodes applying reversibly said breakdown voltage to bias said semiconductor junction;
one electrode provided on said second semiconductor region, said one electrode applying reversibly said breakdown voltage to bias said semiconductor junction with said two output electrodes wherein a bistable condition is obtained at said each of two output electrodes in a fixed reversible reverse breakdown condition of said semiconductor junction;
two identical first resistors, one side terminal of each of said two identical first resistors being connected to one of said two output electrodes; and
an electrical power source coupled between the common terminal of the other side of said two identical first resistors and said one electrode, said power source providing the voltage to bias said semiconductor junction by said breakdown voltage;
(b) two identical trigger pulse generators, said two identical trigger pulse generators each having output terminal, each output terminal being connected to one of said two output electrodes wherein the motion of SR flip-flop is obtained between said two output electrodes by applying the trigger pulses of said two identical trigger pulse generators in said bistable condition.

2. A SR flip-flop according to claim 1 wherein said two identical trigger pulse generators are generators of positive trigger pulses.

3. A SR flip-flop according to claim 1 wherein said two identical trigger pulse generators are generators of negative trigger pulses.

4. A SR flip-flop according to claim 1, 2, or 3 further including two identical second resistors between the output terminals of said two identical trigger pulse generators and said two output electrodes and the base electrical potential of the trigger pulses generated by said two identical trigger pulse generators is the medium of the bistable output potentials.

5. A SR flip-flop according to any of claims 1 to 4 wherein said first conductivity type is n-type and second conductivity type is p-type.

6. A SR flip-flop according to any of claims 1 to 4 wherein said first conductivity type is p-type and second conductivity type is n-type.
